# EUROPEAN PATENT APPLICATION

(11) **EP 4 475 169 A1**
(43) Date of publication of application: **11.12.2024**
(21) Application number: 24180107.5
(22) Date of filing: 05.06.2024
(51) Int. Cl.: H01L 21/67, H01L 21/677

(54) **IN-LIQUID POSTURE TURNING APPARATUS AND SUBSTRATE PROCESSING APPARATUS INCLUDING THE SAME**

(30) Priority: 08.06.2023 JP 2023094827
(71) Applicant: SCREEN Holdings Co., Ltd., Kyoto-shi, Kyoto 602-8585 (JP)
(72) Inventor: TANIGUCHI, Shinichi, Kyoto-shi, 602-8585 (JP); IWASAKI, Akihiro, Kyoto-shi, 602-8585 (JP)
(74) Representative: Kilian Kilian & Partner mbB

(57) **Abstract**

An in-liquid posture turning apparatus for turning a posture of a plurality of substrates, the apparatus including: an immersion tank; a reversing chuck; an opening/closing drive mechanism; a rotating drive mechanism; and a lifting drive mechanism that moves the reversing chuck up and down between a transfer position above the immersion tank and a turning position in the immersion tank, in which in a state where the reversing chuck is moved up to the transfer position, the reversing chuck, which has been set to an open position, is made to receive a plurality of substrates, and after the inversion chuck is set to a holding position, in a state where the inversion chuck is moved down to the turning position, the reversing chuck is driven around a horizontal axis.

## Description

### BACKGROUND OF THE INVENTION

### (1) Field of the Invention

The present invention relates to an in-liquid posture turning apparatus that turns a posture of a substrate such as a semiconductor substrate, a substrate for a flat panel display (FPD) such as a liquid crystal display or an organic electroluminescence (EL) display device, a glass substrate for a photomask, or a substrate for an optical disk, and a substrate processing apparatus including the in-liquid posture turning apparatus.

### (2) Description of the Related Art

Conventionally, this type of apparatus includes a batch type module, a single wafer type module, and an posture turning module. For example, JP 2016-502275 A is referred to. The batch type module collectively processes a plurality of substrates. The single wafer type module performs processing on each substrate. In general, the drying processing by the single wafer type module has a small space of a processing atmosphere in which the substrate is affected and high particle performance as compared with the drying processing by the batch type module. Therefore, the single wafer type module is more likely to enhance the drying performance than the batch type module. Therefore, for example, the etching processing and the rinsing processing may be performed by the batch type module, and then the drying processing may be performed by the single wafer type module.

In the batch type module, processing is performed in a state in which a plurality of substrates are in a vertical posture. On the other hand, in the single wafer type module, the processing is performed in a state where the substrate is in a horizontal posture. Therefore, the substrate in the vertical posture that has been processed by the batch type module is turned to the horizontal posture by the posture turning module before being transported to the single wafer type module. The rotating mechanism includes a reversing chuck in which a groove for cramping the substrate is formed.

Meanwhile, in recent years, in the semiconductor field, definition in a pattern of a three-dimensional structure has been advanced. Therefore, in such a substrate, the pattern may collapse due to the influence of the gas-liquid interface when the substrate is dried. Therefore, the substrate is brought into a wet state so that the substrate is not dried until the processing in the single wafer type module is performed after the processing in the batch type module.

Specifically, a plurality of blowing pipes are arranged in the vicinity of the posture turning module. The blowing pipe blows pure water to the substrate held by the posture turning module. As a result, the substrate held by the posture turning module is brought into a wet state until the substrate is placed on the single wafer type module.

In the apparatus having such a configuration, there is a time during which the entire substrate is not sufficiently wet due to the positional relationship between the posture of the substrate by the posture turning module and the blowing pipe. In addition, even when pure water is sprayed from the vicinity of a rotating mechanism, there is the problem that the entire substrate cannot be sufficiently wetted due to the presence of members of the rotating mechanism.

Therefore, there has been proposed an in-liquid posture turning apparatus including an immersion tank that stores pure water, an in-tank carrier that can be moved up and down inside and above the immersion tank and stores a plurality of substrates, and the rotating mechanism that rotates the in-tank carrier. In this proposed apparatus, the plurality of substrates in a vertical posture are accommodated in the in-tank carrier, and the plurality of substrates are immersed in the immersion tank for each in-tank carrier. In this state, by vertically rotating the in-tank carrier by the rotating mechanism, the posture of the substrates is turned from the vertical posture to the horizontal posture in pure water.

However, the conventional example having such a configuration has the following problems.

That is, since the conventional apparatus rotates the entire in-tank carrier vertically, there is the problem that the size of the immersion tank particularly increases in the vertical direction. In addition, since the plurality of substrates are turned to the horizontal posture for each in-tank carrier, there is also the problem that the load of the rotating mechanism increases.

### SUMMARY OF THE INVENTION

The present invention has been made in view of such circumstances, and an object of the present invention is to provide a posture turning apparatus that can be downsized and reduce the load on a rotating mechanism, and a substrate processing apparatus including the posture turning apparatus.

In order to achieve such an object, the present invention has the following configuration.

That is, the present invention is an in-liquid posture turning apparatus that turns a posture of a plurality of substrates, the apparatus including the following elements: an immersion tank that stores a processing liquid; a reversing chuck that holds a plurality of substrates; an opening/closing drive mechanism that drives the reversing chuck to an open position for transferring the plurality of substrates to the reversing chuck and a holding position for holding the plurality of substrates by the reversing chuck; a rotating drive mechanism that drives the reversing chuck about a horizontal axis in order to turn the posture of the plurality of substrates; and a lifting drive mechanism that moves the reversing chuck up and down between a transfer position above the immersion tank and a turning position in the immersion tank, in which in a state where the reversing chuck is moved up to the transfer position by the lifting drive mechanism, the reversing chuck, which has been set to the open position by the opening/closing drive mechanism, is made to receive the plurality of substrates, and after the inversion chuck is set to the holding position by the opening/closing drive mechanism, in a state where the inversion chuck is moved down to the turning position by the lifting drive mechanism, the reversing chuck is driven around a horizontal axis by the rotating drive mechanism.

According to the present invention, the reversing chuck is moved up to the transfer position by the lifting drive mechanism. The opening/closing drive mechanism causes the reversing chuck, which has been set to the open position, to receive the plurality of substrates, and the opening/closing drive mechanism sets the reversing chuck to the holding position. The reversing chuck is moved down to the turning position by the lifting drive mechanism. The reversing chuck is driven around the horizontal axis by the rotating drive mechanism. As a result, the posture of the plurality of substrates can be turned in the immersion tank. Since the plurality of substrates are held by the reversing chuck instead of the in-tank carrier, the immersion tank can be downsized. In addition, since only the plurality of substrates and the reversing chuck are rotated about the horizontal axis, the load on the rotating mechanism can be reduced.

Further, in the present invention, it is preferable that the rotating drive mechanism includes a rotary shaft whose one end side is coupled to the outside of the reversing chuck, a motor, and a transmission mechanism that transmits a rotational force of the motor to the rotary shaft, the rotating drive mechanism further includes a bottomed container that accommodates the rotary shaft and the transmission mechanism, and the transmission mechanism is moved up and down together with the container by the lifting drive mechanism.

The transmission mechanism is accommodated in the bottomed container and is moved up and down by the lifting drive mechanism. Therefore, the reversing chuck in the processing liquid in the immersion tank can be rotated about the horizontal axis. In addition, since the transmission mechanism is accommodated in the container, it is possible to prevent particles from being mixed into the processing liquid in the immersion tank and contaminating the substrate even if particles are generated by the transmission mechanism.

Further, in the present invention, it is preferable that the transmission mechanism includes a driven pulley provided on the other end side of the rotary shaft, a main driving pulley attached to the motor, and a timing belt stretched between the driven pulley and the main driving pulley.

The rotational force of the motor is transmitted to the reversing chuck by the timing belt stretched between the main driving pulley and the driven pulley. Therefore, the weight of the transmission mechanism can be reduced. As a result, the load on the lifting drive mechanism can be reduced.

Further, in the present invention, it is preferable that the transmission mechanism includes a first bevel gear provided on the other end side of the rotary shaft, an extension shaft coupled to the motor, and a second bevel gear provided at a lower end portion of the extension shaft and screwed with the first bevel gear.

The rotational force of the extension shaft coupled to the motor is transmitted to the reversing chuck by the first bevel gear and the second bevel gear. In the timing belt, transmission loss may occur due to expansion and contraction. However, since the rotational force is transmitted by the gear, transmission loss of the rotational force can be reduced.

Further, in the present invention, it is preferable that the lifting drive mechanism includes a lifting frame on which the rotating drive mechanism is mounted and which extends to the outside of the immersion tank and the container, and the opening/closing drive mechanism is mounted on the lifting frame.

When the lifting drive mechanism moves up and down the lifting frame, the opening/closing drive mechanism and the rotating drive mechanism can also move up and down simultaneously. Therefore, the configuration can be simplified.

Further, in the present invention, it is preferable that the inside of the container is pressurized with a gas.

Since the container is pressurized, it is possible to prevent the processing liquid in the immersion tank from entering the container. Therefore, it is possible to prevent a failure caused by the processing liquid entering the container.

Further, the present invention is a substrate processing apparatus for processing a substrate, the apparatus including the following elements: a batch type processing unit that collectively processes a plurality of substrates in a vertical posture; a single wafer type processing unit that processes one substrate in a horizontal posture; an in-liquid posture turning unit that turns a vertical posture to a horizontal posture in a processing liquid for the plurality of substrates that have been processed by the batch type processing unit; a first transport unit that transports the plurality of substrates, which have been processed by the batch-type processing unit, to the in-liquid posture turning unit; and a second transport unit that transports the plurality of substrates brought into a horizontal posture by the in-liquid posture turning unit to the single wafer type processing unit, in which the in-liquid posture turning unit includes: an immersion tank that stores a processing liquid; a reversing chuck that holds a plurality of substrates; an opening/closing drive mechanism that drives the reversing chuck to an open position for transferring the plurality of substrates to the reversing chuck and a holding position for holding the plurality of substrates by the reversing chuck; a rotating drive mechanism that drives the reversing chuck about a horizontal axis in order to turn a posture of the plurality of substrates into a vertical posture and a horizontal posture; and a lifting drive mechanism that moves up and down the reversing chuck between a transfer position above the immersion tank and a turning position in the immersion tank, in which in a state where the reversing chuck is moved up to the transfer position by the lifting drive mechanism, the reversing chuck, which has been set to the open position by the opening/closing drive mechanism, is made to receive the plurality of substrates, and after the inversion chuck is set to the holding position by the opening/closing drive mechanism, in a state where the reversing chuck is moved down to the turning position by the lifting drive mechanism, the reversing chuck is driven around the horizontal axis by the rotating drive mechanism so as to turn the plurality of substrates from the vertical posture to the horizontal posture.

According to the present invention, the reversing chuck is moved up to the transfer position by the lifting drive mechanism of the in-liquid posture turning unit. The opening/closing drive mechanism causes the reversing chuck, which has been set to the open position, to receive the plurality of substrates, and the opening/closing drive mechanism sets the reversing chuck to the holding position. The reversing chuck is moved down to the turning position by the lifting drive mechanism. The reversing chuck is driven around the horizontal axis by the rotating drive mechanism. As a result, the plurality of substrates processed by the batch type processing unit can be transported to the in-liquid posture turning unit by the first transport unit, and can be turned from the vertical posture to the horizontal posture in the immersion tank. Thereafter, the substrates can be transported to the single wafer type processing unit by the second transport unit. Since the in-liquid posture turning unit holds the plurality of substrates with the reversing chuck instead of the in-tank carrier, the immersion tank can be downsized. In addition, since only the plurality of substrates and the reversing chuck are rotated about the horizontal axis, the load on the rotating mechanism can be reduced.

The present specification also discloses an invention related to the following in-liquid posture turning apparatus.

In the batch processing, processing is performed by immersing a plurality of substrates in a vertical posture in a processing liquid in a state where the processing liquid is stored in an immersion tank. At this time, the processing liquid is supplied upward from the bottom surface of the immersion tank in an up-flow manner, and the processing liquid is discharged over the upper edge of the immersion tank. By maintaining such a state for a predetermined time, processing is collectively performed on a plurality of substrates.

However, in the plurality of substrates in the vertical posture, the degree of progress of processing may be different between the lower portion and the upper portion. That is, there is the problem that it is difficult to uniformly perform the processing in the plane of the substrate. In other words, it is difficult to improve in-plane uniformity.

Another object of the present invention has been made in view of such circumstances, and is to provide an in-liquid posture turning apparatus that can improve in-plane uniformity by vertically reversing a substrate during processing.
(1) An in-liquid posture turning apparatus that turns a posture of a plurality of substrates, the apparatus including the following elements:
   an immersion tank that stores a processing liquid;
   a reversing chuck that holds a plurality of substrates;
   an opening/closing drive mechanism that drives the reversing chuck to an open position for transferring the plurality of substrates to the reversing chuck and a holding position for holding the plurality of substrates by the reversing chuck;
   a rotating drive mechanism that drives the reversing chuck about a horizontal axis in order to turn the posture of the plurality of substrates; and
   a lifting drive mechanism that moves the reversing chuck up and down between a transfer position above the immersion tank and a turning position in the immersion tank, in which
   in a state where the reversing chuck is moved up to the transfer position by the lifting drive mechanism, the reversing chuck, which has been set to the open position by the opening/closing drive mechanism, is made to receive the plurality of substrates, and after the inversion chuck is set to the holding position by the opening/closing drive mechanism, in a state where the inversion chuck is moved down to the turning position by the lifting drive mechanism, processing with the processing liquid is performed on the plurality of substrates, and the reversing chuck is driven around a horizontal axis by the rotating drive mechanism so as to vertically invert the plurality of substrates.
      According to the present invention, the plurality of substrates are processed with the processing liquid in the immersion tank, and the reversing chuck is driven around the horizontal axis by the rotating drive mechanism to vertically invert the plurality of substrates. Therefore, the upper portion and the lower portion of the substrate can be inverted. Therefore, even if the degree of progress of the processing is different between the upper portion and the lower portion of the substrate, the degree of progress of the processing can be averaged by the inversion. As a result, in-plane uniformity can be enhanced.
(2) It is preferable in (1) that the vertical inversion is performed after the processing with the processing liquid is performed for a predetermined time, and in the vertically inverted state, the processing is further performed for the same amount of time as the previously performed processing time with the processing liquid.

The processing with the processing liquid is performed after the vertical inversion for the same amount of time as the processing time with the processing liquid performed before the vertical inversion. Therefore, the upper portion and the lower portion of the substrate can be uniformly processed. As a result, the in-plane uniformity of the processing can be improved.

### BRIEF DESCRIPTION OF THE DRAWINGS

For the purpose of illustrating the invention, there are shown in the drawings several forms which are presently preferred, it being understood, however, that the invention is not limited to the precise arrangement and instrumentalities shown.
FIG. 1 is a plan view showing an overall configuration of a substrate processing apparatus according to an embodiment;
FIG. 2 is a cross-sectional view taken along line A-A in FIG. 1;
FIG. 3 is a plan view showing a configuration of a 25-piece chuck and a reversing chuck;
FIG. 4 is a front view in a state where the reversing chuck is set to an open position;
FIG. 5 is a front view in a state where the reversing chuck is set to a holding position;
FIG. 6 is a front view illustrating a configuration of a posture turning tank and showing a state in which a substrate is held in a vertical posture;
FIG. 7 is a front view illustrating a configuration of a posture turning tank and showing a state in which a substrate is held in a horizontal posture;
FIG. 8 is a partially broken front view showing a detailed structure of the posture turning tank;
FIG. 9 is another embodiment of the posture turning tank, and is a partially broken front view showing a detailed structure;
FIG. 10 is a front view for explaining another operation example by the posture turning tank; and
FIG. 11 is a front view for explaining another operation example by the posture turning tank.

### DESCRIPTION OF THE PREFERRED EMBODIMENTS

Hereinafter, preferred embodiments of the present invention will be described in detail with reference to the drawings.

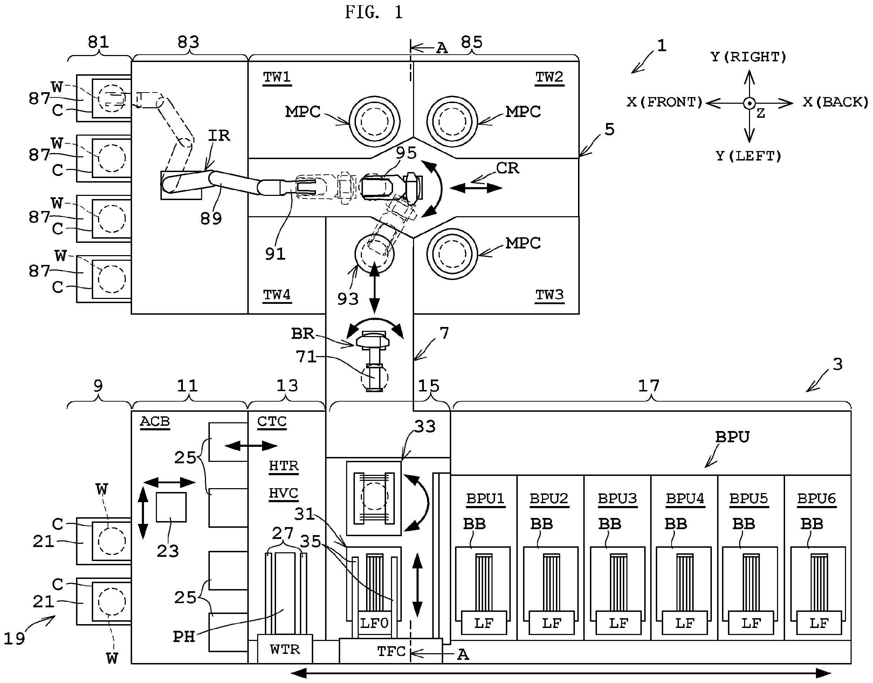

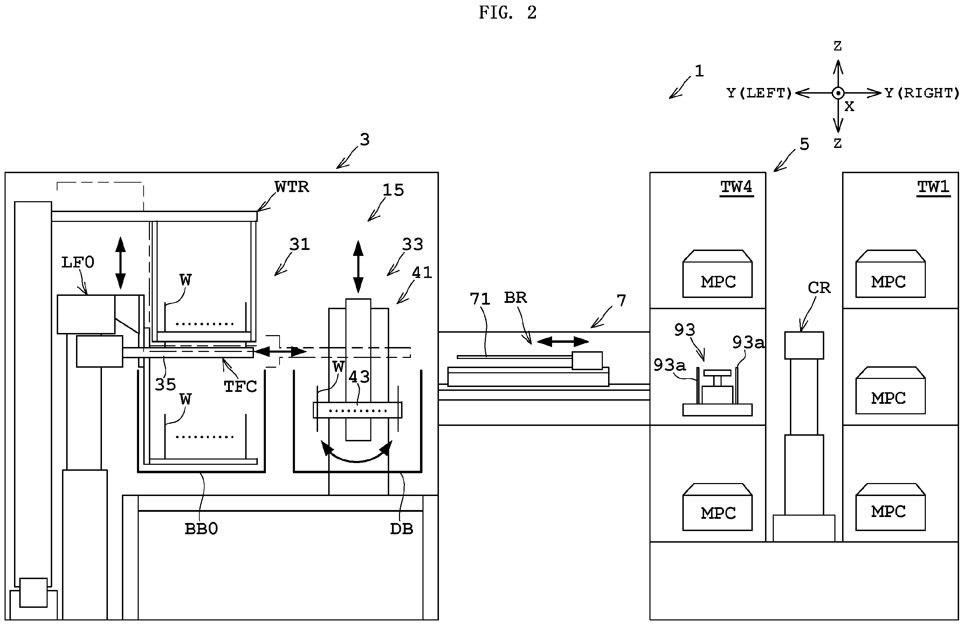

FIG. 1 is a plan view showing an overall configuration of a substrate processing apparatus according to an embodiment. FIG. 2 is a cross-sectional view taken along line A-A in FIG. 1.

### <1. Overall configuration>

A substrate processing apparatus 1 processes a substrate W. The substrate processing apparatus 1 performs, for example, chemical liquid processing, cleaning processing, drying processing, and the like on the substrate W. The substrate processing apparatus 1 adopts a processing method (so-called hybrid method) having both a batch type and a single wafer type. The batch type collectively processes a plurality of substrates W in a vertical posture. The single wafer type processes one substrate W in a horizontal posture.

The substrate processing apparatus 1 includes a batch type processing apparatus 3 and a single wafer type processing apparatus 5. In the present embodiment, the single wafer type processing apparatus 5 is disposed adjacent to the batch type processing apparatus 3. The batch type processing apparatus 3 and the single wafer type processing apparatus 5 are disposed apart from each other. The batch type processing apparatus 3 and the single wafer type processing apparatus 5 are coupled by a bridging unit 7.

### <2. Batch type processing apparatus>

The batch type processing apparatus 3 collectively processes a plurality of substrates W. The batch type processing apparatus 3 includes a loading block 9, a stocker block 11, a transfer block 13, a posture turning block 15, and a processing block 17.

In the present specification, for convenience, a direction in which the loading block 9, the stocker block 11, the transfer block 13, and the processing block 17 are arranged is referred to as a "front-back direction X". The front-back direction X is horizontal. Of the front-back direction X, the direction from the stocker block 11 toward the loading block 9 is referred to as "front side". A direction opposite to the front side is referred to as "back side". A horizontal direction orthogonal to the front-back direction X is referred to as a "width direction Y". One direction in the "width direction Y" is appropriately referred to as a "right side". A direction opposite to the right side is referred to as "left side". A direction perpendicular to the horizontal direction is referred to as a "vertical direction Z". In each drawing, front, back, upper, lower, right, and left are appropriately shown for reference.

### <3. Loading block>

The loading block 9 includes a charging unit 19. The charging unit 19 is disposed at the front side X of the batch type processing apparatus 3. A carrier C stacks and stores the plurality of (for example, 25-sheets) substrates W in the vertical direction Z at constant intervals in the horizontal posture. In the carrier C, a plurality of grooves (not illustrated) for accommodating the substrates W one by one are formed with the surfaces of the substrates W separated from each other. As the carrier C, for example, there is a front opening unify pod (FOUP). The FOUP is a sealed container. The carrier C may be an open type container and may be of any type. The charging unit 19 includes, for example, two placing tables 21 on which the carrier C is placed. The two placing tables 21 are arranged, for example, along the width direction Y. The charging unit 19 is also referred to as a load port.

### <4. Stocker block>

The stocker block 11 is disposed adjacent to the back side X of the loading block 9. The stocker block 11 includes a transport storage unit ACB. The transport storage unit ACB includes a transport mechanism 23 and a shelf 25.

The transport mechanism 23 transports the carrier C. The transport storage unit ACB includes a plurality of shelves 25. The shelf 25 includes one on which the carrier C is simply temporarily placed and one on which the carrier C is placed for transfer between a first transport mechanism HTR. The transport storage unit ACB takes in the carrier C storing the unprocessed substrate W from the charging unit 19 and places the carrier C on the shelf 25. The transport storage unit ACB transports and places the carrier C on the transfer shelf 25 according to the schedule that defines the order of processing. The transport storage unit ACB transports and places the carrier C, which has been placed on the transfer shelf 25 and has become empty, on the shelf 25. The transport storage unit ACB carries out the empty carrier C placed on the shelf 25 to the placing table 21 according to the availability of the placing table 21. The empty carrier C is transported to the single wafer type processing unit 5. In the empty carrier C transported to the single wafer type processing unit 5, for example, the substrate W that has been stored in the carrier C before processing and has been processed is stored in the single wafer type processing unit 5.

### <5. Transfer block>

The transfer block 13 is disposed adjacent to the back side X of the stocker block 11. The transfer block 13 includes a transfer mechanism CTC. The transfer mechanism CTC includes the first transport mechanism HTR, a turning mechanism HVC, a pusher PH, and a second transport mechanism WTR.

The first transport mechanism HTR is disposed at the right side Y of the back side X of the transport storage unit ACB. The first transport mechanism HTR collectively transports the plurality of substrates W. In other words, the first transport mechanism HTR includes a plurality of hands (not illustrated). One hand supports one substrate W. The first transport mechanism HTR can also convey only one substrate W. The first transport mechanism HTR collectively takes out a plurality of substrates W (for example, 25-sheets) from the carrier C placed on the transfer shelf 25 in the transport storage unit ACB, and transports the substrates W to the turning mechanism HVC in the horizontal posture. At this time, the turning mechanism HVC orientates the posture of the substrate W from the horizontal posture to the vertical posture.

The turning mechanism HVC and the pusher PH are sequentially arranged in the left side Y of the first transport mechanism HTR. The turning mechanism HVC transfers the plurality of substrates W to the pusher PH. After receiving the plurality of substrates W from the turning mechanism HVC, the pusher PH moves to the second transport mechanism WTR in the width direction Y. At that time, the turning mechanism HVC and the pusher PH assemble a batch lot or release a batch lot. The pusher PH transfers the plurality of substrates W to the second transport mechanism WTR.

For example, the transfer mechanism CTC combines the plurality of substrates W constituting one lot extracted from one carrier C and the plurality of substrates W constituting another lot extracted from another carrier C as one batch lot. This is the assembly of the batch lot. The batch lot includes twice as many substrates W as one lot. In the batch lot, each substrate W of another lot is arranged so as to be adjacent to each substrate W of one lot. That is, each substrate W of one lot is arranged in odd-numbered order, and each substrate W of the other one lot is arranged in even-numbered order. Usually, the interval between the plurality of substrates W extracted from the carrier C is the same as that of the carrier C. This is called full pitch. In one batch lot, for example, the interval between the plurality of substrates W is half the full pitch. This is called half pitch. One lot and the other lot are combined as described above, but there are two types of batch lots, that is, surface matching (also referred to as face to face) and front and back surface matching (also referred to as back to face) depending on how they are combined. How to combine the lots is determined by the operation of the pusher PH. Note that details of this operation will be omitted in order to facilitate understanding of the present invention. In the following description, the plurality of substrates W are referred to as a lot, but in a case where a description unique to a batch lot is required, the plurality of substrates W are referred to as a batch lot.

The second transport mechanism WTR is disposed at the left side Y of the transfer mechanism CTC. The second transport mechanism WTR is configured to be movable between the transfer block 13 and the processing block 17. The second transport mechanism WTR is configured to be movable in the front-back direction X. The second transport mechanism WTR includes a pair of hands 27 that transports a lot. The pair of hands 27 includes, for example, a rotary shaft oriented in the width direction Y. The pair of hands 27 swings around the rotary shaft. The pair of hands 27 clamps the side end surfaces located in the front-back direction X of the plurality of substrates W constituting the lot. The second transport mechanism WTR transfers the plurality of substrates W constituting the lot between the transfer mechanism CTC. The second transport mechanism WTR transfers a plurality of unprocessed substrates W constituting a lot to the processing block 17. The second transport mechanism WTR transfers the plurality of substrates W processed in the processing block 17 between the posture turning block 15.

Here, the processing block 17 will be described before describing the posture turning block 15.

### <6. Processing block>

The processing block 17 includes, for example, a batch processing unit BPU. For example, the batch processing unit BPU includes six processing units. Specifically, the batch processing unit BPU includes a first batch processing unit BPU1, a second batch processing unit BPU2, a third batch processing unit BPU3, a fourth batch processing unit BPU4, a fifth batch processing unit BPU5, and a sixth batch processing unit BPU6. The number of the batch processing units BPU is not limited to six. That is, the number of batch processing units BPU may be less than six, or may be seven or more.

The first batch processing unit BPU1 to the sixth batch processing unit BPU6 are arranged in a line in the front-back direction X. Each of the first batch processing unit BPU1 to the sixth batch processing unit BPU6 includes a processing tank BB and a lifter LF. The processing tank BB stores the processing liquid. The processing liquid is pure water or a chemical liquid. The chemical liquid is, for example, an organic solvent or an etching liquid. The organic solvent is, for example, isopropyl alcohol (IPA). The etching solution is, for example, a phosphoric acid solution.

The lifter LF moves up and down between a processing position inside the processing tank BB and a transfer position above the liquid level of the processing tank BB. The lifter LF transfers the plurality of substrates W to the second transport mechanism WTR at the transfer position. The first batch processing unit BPU1 to the sixth batch processing unit BPU6 are associated with each pair, for example. Specifically, the first batch processing unit BPU1 and the second batch processing unit BPU2 form one pair, the third batch processing unit BPU3 and the fourth batch processing unit BPU4 form one pair, and the fifth batch processing unit BPU5 and the sixth batch processing unit BPU6 form one pair. For example, one pair is divided into a role of chemical liquid processing and a role of cleaning processing. The first batch processing unit BPU1 to the sixth batch processing unit BPU6 can collectively process, for example, up to fifty substrates W. In other words, the first batch processing unit BPU1 to the sixth batch processing unit BPU6 can simultaneously process, for example, at most one batch lot.

The processing liquid is supplied from below to each processing tank BB. In each processing tank BB, the processing liquid is discharged beyond the upper edge. Each processing tank BB immerses the plurality of substrates W placed on the lifter LF in the processing liquid. Each lifter LF holds the lower edge of the substrate W in contact with the lower edge. Each lifter LF transfers a plurality of substrates W between the second transport mechanism WTR.

### <7. Posture turning block>

As illustrated in FIG. 2, the posture turning block 15 includes a 25-piece chuck TFC, a standby tank 31, and an posture turning tank 33. In the drawings being referred for the standby tank 31 and the posture turning tank 33, the liquid level is not illustrated so that each configuration can be easily seen.

The standby tank 31 includes a processing tank BB0 and a lifter LF0. The processing tank BB0 has the same configuration as the processing tank BB provided in the first batch processing unit BPU1 to the sixth batch processing unit BPU6 described above. The lifter LF0 moves up and down between a standby position inside the processing tank BB0 and a transfer position above the liquid level of the processing tank BB0. The standby tank BB0 stores the processing liquid. The processing liquid is, for example, pure water. At the standby position, the entire substrate W placed on the lifter LF0 is immersed in the processing liquid.

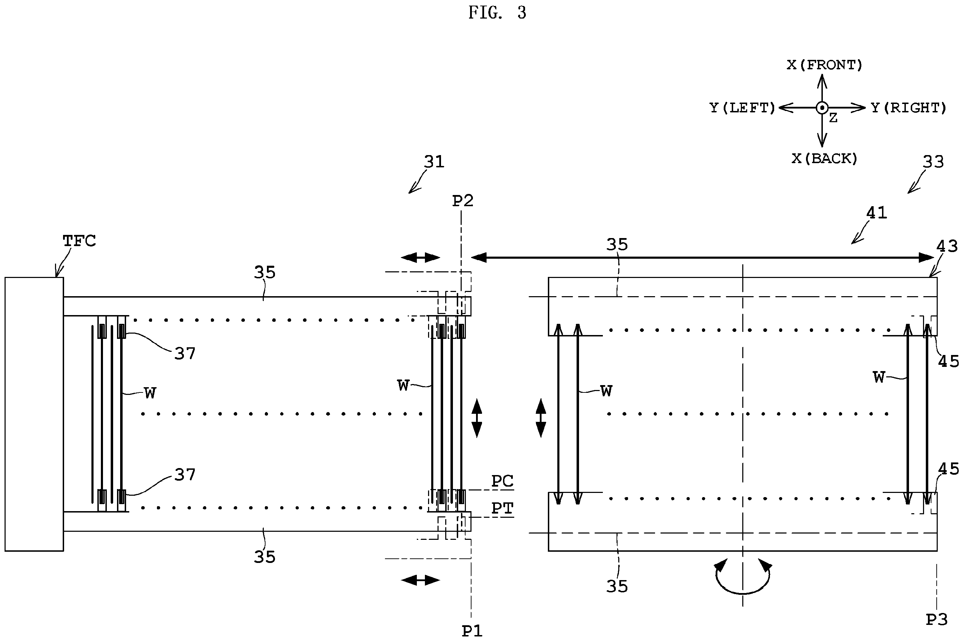

Here, refer to FIG. 3. FIG. 3 is a plan view showing a configuration of the 25-piece chuck and the reversing chuck.

The entire 25-piece chuck TFC horizontally moves only in the width direction Y. The 25-piece chuck TFC does not move up and down in the vertical direction Z. The 25-piece chuck TFC does not horizontally move in the front-back direction X. However, the 25-piece chuck TFC opens and closes a hand 35 between a holding position PC and a passing position PT. At the holding position PC, the 25-piece chuck TFC holds the plurality of substrates W. At the passing position PT, the 25-piece chuck TFC does not hold the plurality of substrates W. In other words, the passing position PT allows the lifter LF0 holding the plurality of substrates W to move between the transfer position and the standby position. For example, the 25-piece chuck TFC moves over three positions of a first transfer position P1, a second transfer position P2, and a third transfer position P3 in the width direction Y.

The 25-piece chuck TFC includes locking portions 37. The locking portions 37 are provided inside the hand 35. The locking portions 37 are formed in the width direction Y at intervals of the full pitch described above. The first transfer position P1 and the second transfer position P2 are different in position in the width direction Y by a distance corresponding to a half pitch. The third transfer position P3 is a position where the plurality of substrates W are transferred to the posture turning tank 33. The 25-piece chuck TFC receives only one lot from the lifter LF0 at the first transfer position P1. Specifically, only a plurality of odd numbered substrates W constituting the first lot among two lots constituting the batch lot are received. The 25-piece chuck TFC receives only the other lot from the lifter LF0 at the second transfer position P2. Specifically, only a plurality of even-numbered substrates W constituting the next lot among two lots constituting the batch lot are received.

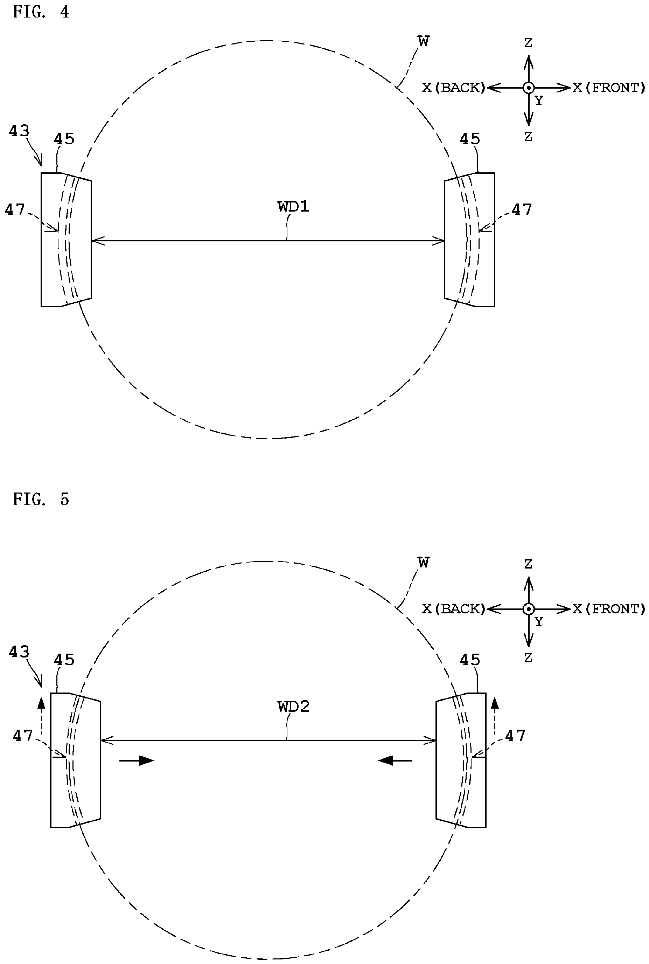

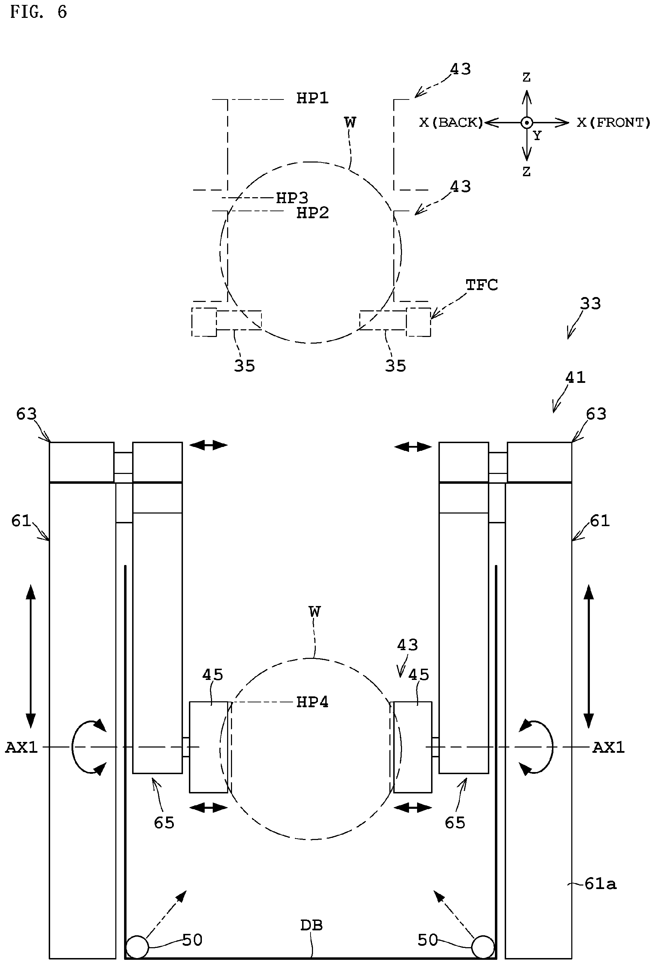

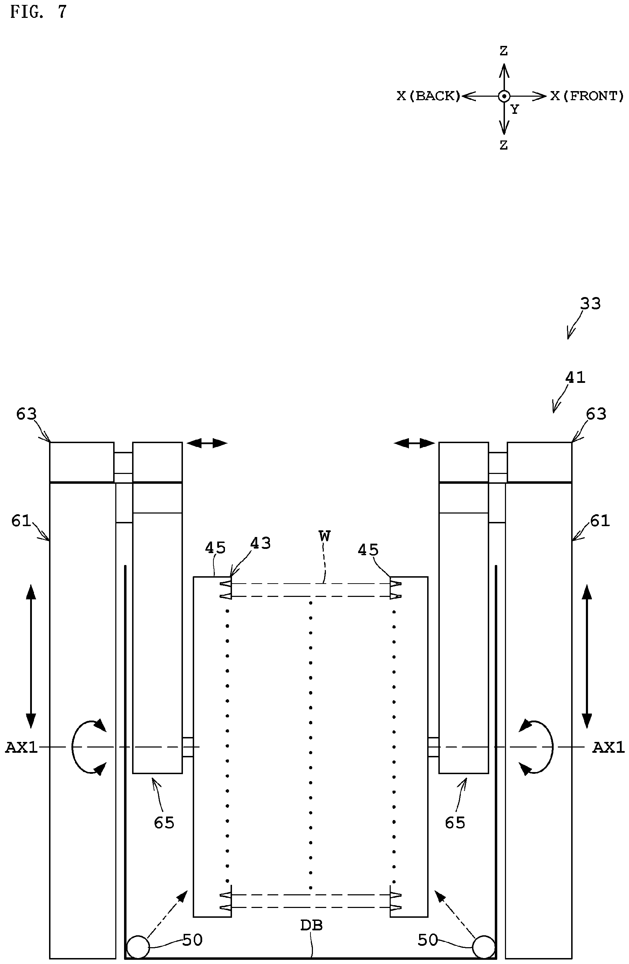

Here, in addition to FIGS. 2 and 3, FIGS. 4 to 7 will be further referred to. FIG. 4 is a front view in a state in which the reversing chuck is set to a first interval. FIG. 5 is a front view in a state where the reversing chuck is set to a second interval. FIG. 6 is a transverse cross-sectional view in a state where the reversing chuck is set to a first interval. FIG. 7 is a transverse cross-sectional view in a state where the reversing chuck is set to a second interval.

As illustrated in FIG. 2, the posture turning tank 33 includes an immersion tank DB and an posture turning unit 41.

First, the main part will be described. The posture turning tank 33 collectively turns the posture of the plurality of substrates W by the reversing chuck 43 in the immersion tank DB. Specifically, the reversing chuck 43 turns the plurality of substrates W from the vertical posture to the horizontal posture. For example, the reversing chuck 43 turns the posture of half of the substrates W constituting the batch lot. For example, the reversing chuck 43 turns the posture of twenty five substrates W. The reversing chuck 43 is disposed to face each other in the radial direction of the substrate W and clamps a peripheral edge portion of the substrate W. The immersion tank DB stores the processing liquid. The processing liquid is, for example, pure water.

As illustrated in FIGS. 4 and 5, the reversing chuck 43 includes a pair of chuck members 45. In the chuck member 45, the length in the vertical direction Z when receiving and holding the substrate W in the vertical posture is shorter than the radius of the substrate W. As illustrated in FIG. 3 and 7, in the chuck member 45, the length in the width direction Y when receiving and holding the substrates W in the vertical posture is slightly longer than the length in the alignment direction of the plurality of substrates W in the lot.

As illustrated in FIGS. 4 and 5, each of the chuck members 45 has a groove portion 47 on the opposing surface. The groove portion 47 has an arc shape when viewed from the width direction Y in the vertical posture in which the substrate W in the vertical posture is received and held. The arc shape of the groove portion 47 is a shape along the outer edge of the substrate W.

The pair of chuck members 45 moves in the front-back direction X across a first interval WD1 and a second interval WD2. The pair of chuck members 45 can turn the distance between the groove portions 47 facing each other. The first interval WD1 is an interval for transferring the substrates between the 25-piece chuck TFC and the bridging unit 7. The second interval WD2 is an interval that is narrower in the front-back direction X than the first interval WD1 and is for clamping the plurality of substrates W.

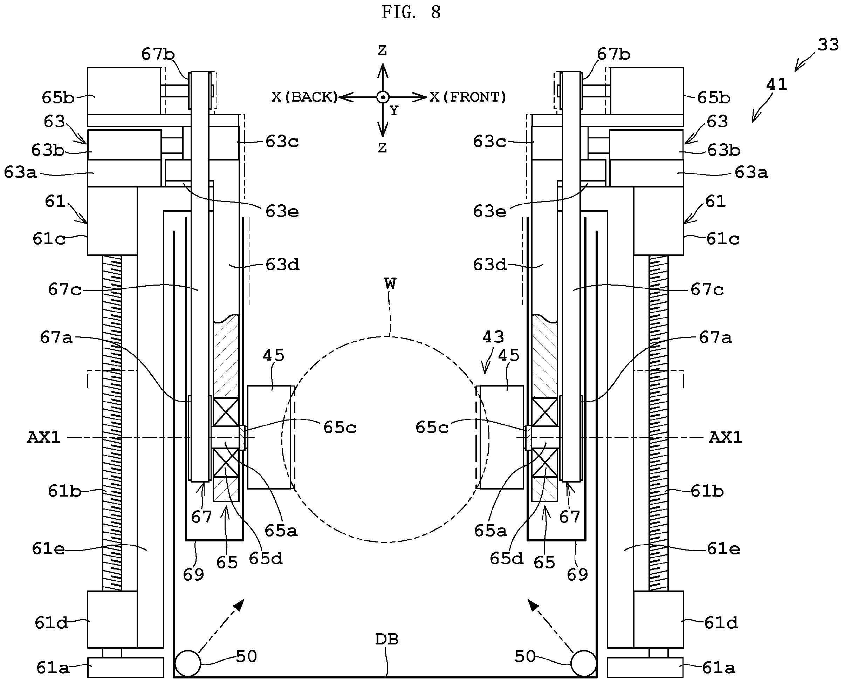

Here, FIG. 8 will be further referred to. FIG. 8 is a partially broken front view showing a detailed structure of the posture turning tank.

An immersion tank DB includes a pair of supply pipes 50. Each of the supply pipes 50 is disposed at the bottom of the immersion tank DB. Each of the supply pipes 50 is disposed at a corner of the immersion tank DB in a front-back direction X. Each of the supply pipes 50 extends in a width direction Y. Each of the supply pipes 50 ejects and supplies the processing liquid upward at the central portion in the front-back direction X of the immersion tank DB, that is, obliquely upward. In other words, each of the supply pipes 50 ejects the processing liquid toward the vicinity of the central portion of a substrate W in a state where the substrate W is immersed in the immersion tank DB.

Note that each of the supply pipes 50 may jet and supply the processing liquid toward the central portion of the bottom surface of the immersion tank DB. As a result, the processing liquid is once applied to the bottom surface of the immersion tank DB and then rises toward the central portion of the substrate W. Therefore, a strong flow of the processing liquid does not directly hit the substrate W. As a result, the processing unevenness caused by the liquid flow of the processing liquid can be suppressed, and the in-plane uniformity can be further improved.

A posture turning tank 33 includes a lifting mechanism 61, a drive mechanism 63, and a rotating mechanism 65.

The lifting mechanism 61 moves up and down the reversing chuck 43. The drive mechanism 63 opens and closes the reversing chuck 43. The rotating mechanism 65 rotates the reversing chuck 43.

The lifting mechanism 61 is disposed outside the immersion tank DB. The lifting mechanism 61 is disposed along outer surfaces of two side walls provided in the front-back direction X among the four side walls of the immersion tank DB in plan view. As illustrated in FIG. 6, the lifting mechanism 61 is moved up and down over a receiving height HP1, a clamping height HP2, a locking height HP3, and an immersion height HP4 of the reversing chuck 43. The receiving height HP1 is a height for receiving the substrate W in the vertical posture to the reversing chuck 43. The clamping height HP2 is a height for clamping the substrate W in the vertical posture by the reversing chuck 43. The locking height HP3 is a height for locking the substrate W in the vertical posture clamped by the reversing chuck 43. The immersion height HP4 is a height for immersing the substrate W in the vertical posture locked by the reversing chuck 43 in the processing liquid in the immersion tank DB.

The lifting mechanism 61 includes a base member 61a, a screw shaft 61b, a motor 61c, a lifting member 61d, and a lifting frame 61e.

The base member 61a is fixed to the bottom of the posture turning tank 33. The screw shaft 61b is erected in a vertical direction Z from the base member 61a. The screw shaft 61b extends in the vertical direction Z. The screw shaft 61b is disposed along the outer surface of the immersion tank DB. The motor 61c is attached to an upper portion of the screw shaft 61b. A rotary shaft of the motor 61c is oriented downward. The rotary shaft of the motor 61c is coupled to the screw shaft 61b. The lifting member 61d is screwed to the screw shaft 61b. The lifting member 61d moves up and down in the vertical direction Z by the rotation of the screw shaft 61b. The lifting frame 61e is coupled to the lifting member 61d. A lower portion of the lifting frame 61e is coupled to the lifting member 61d. The lifting frame 61e has an inverted L shape.

The drive mechanism 63 is mounted on an upper portion of the lifting mechanism 61. The drive mechanism 63 includes an upper base member 63a, an air cylinder 63b, a moving piece 63c, a suspension arm 63d, and a linear guide 63e. The upper base member 63a is disposed above the motor 61c and the lifting frame 61e. The air cylinder 63b is attached to the upper base member 63a. A working axis of the air cylinder 63b is oriented in the front-back direction X. The suspension arm 63d has an inverted L shape. The suspension arm 63d has a horizontal portion attached to an upper portion of the lifting frame 61e via the linear guide 63e. The suspension arm 63d is attached by the linear guide 63e so as to be horizontally movable in the front-back direction X. The suspension arm 63d is movable in the horizontal direction with respect to the lifting frame 61e. The drive mechanism 63 moves the suspension arm 63d in the front-back direction X by operating the air cylinder 63b. The drive mechanism 63 moves a chuck member 45 over a first interval WD1 and a second interval WD2 by operating the air cylinder 63b.

For example, the working axis of the air cylinder 63b contracts when not in operation. For example, the working axis of the air cylinder 63b extends during operation. That is, when the air cylinder 63b is not operated, a reversing chuck 43 is set to the first interval WD1. When the air cylinder 63b is in operation, the reversing chuck 43 is set to the second interval WD2.

The rotating mechanism 65 includes a rotary shaft 65a, a motor 65b, and a transmission mechanism 67.

One end of the rotary shaft 65a is coupled to the outer surface of the chuck member 45. The motor 65b is attached to an upper portion of the moving piece 63c. The motor 65b is disposed horizontally. The other end of the rotary shaft 65a is accommodated in a container 69. The rotary shaft 65a is attached to the container 69 via a seal member 65c. The seal member 65c supports the rotary shaft 65a in a liquid-tight state. The rotary shaft 65a is attached to the suspension arm 63d via a bearing 65d. The bearing 65d rotatably supports the rotary shaft 65a around an axis AX1. The other end of the rotary shaft 65a protrudes in the front-back direction X from the outer surface of the suspension arm 63d.

It is preferable to use a mechanical seal or a VL seal as the above-described seal member 65c. The mechanical seal is a seal that forms a liquid film on a sliding surface and seals the sliding surface while performing a lubricating action with a liquid to be sealed. The VL seal is a seal that tightens and seals an L-shaped seal ring with an O-ring.

The container 69 is bottomed. The container 69 does not include a ceiling surface. In other words, an upper surface of the container 69 communicates with the periphery. When the reversing chuck 43 is positioned at an immersion height HP4, the container 69 has an upper edge positioned above an upper edge of the immersion tank DB. That is, the container 69 is not immersed in the processing liquid in the immersion tank DB. The container 69 is driven to move up and down in the vertical direction Z by the lifting mechanism 61 together with the suspension arm 63d.

The transmission mechanism 67 transmits the rotational force of the motor 65b to the rotary shaft 65a.

Specifically, the transmission mechanism 67 includes a driven pulley 67a, a main driving pulley 67b, and a timing belt 67c. The driven pulley 67a is fixed to the other end of the rotary shaft 65a. The main driving pulley 67b is attached to the motor 65a. The main driving pulley 67b is rotationally driven by the motor 65a. The timing belt 67c is stretched between the driven pulley 67a and the main driving pulley 67b. When the motor 65b is rotated, the rotary shaft 65a is rotationally driven around the axis AX1 via the main driving pulley 67b, the timing belt 67c, and the driven pulley 67a. As a result, the reversing chuck 43 is rotationally driven around the axis AX1.

The drive mechanism 63 and the rotating mechanism 65 are mounted on the lifting mechanism 61. Therefore, the drive mechanism 63 and the rotating mechanism 65 are moved up and down in the vertical direction Z by the lifting mechanism 61. The rotating mechanism 65 is mounted on the drive mechanism 63. Therefore, the rotating mechanism 65 is moved in the front-back direction X by the drive mechanism 63.

The transmission mechanism 67 transmits the rotational force of the motor 65b to the reversing chuck 43 by the timing belt 67c stretched between the main driving pulley 67b and the driven pulley 67a. Therefore, the weight of the transmission mechanism 67 can be reduced. As a result, the load on the lifting mechanism 61 can be reduced.

The container 69 is driven to move up and down in the vertical direction Z by the lifting mechanism 61 together with the suspension arm 63d. Therefore, even if particles are generated in the rotating mechanism 65 or the transmission mechanism 67, the particles do not enter the processing liquid in the immersion tank DB. As a result, it is possible to prevent the substrate W from being contaminated at the time of posture turn.

Here, the description returns to FIGS. 1 and 2.

### <8. Bridging unit>

The bridging unit 7 couples the batch type processing apparatus 3 and the single wafer type processing apparatus 5. The bridging unit 7 communicates only with the batch type processing apparatus 3 and the single wafer type processing apparatus 5. The bridging unit 7 includes a bridge robot BR. The bridge robot BR is configured to be movable only in the width direction Y. The bridge robot BR does not move up and down in the vertical direction Z. The bridge robot BR includes a hand 71. The hand 71 is configured to be rotatable in a horizontal plane including the front-back direction X and the width direction Y. The hand 71 is configured to be stretchable in the horizontal direction. The bridge robot BR moves the hand 71 forward and backward so as to receive one substrate in a horizontal posture from the posture turning block 15. The bridge robot BR transfers one substrate set in a horizontal posture to the single wafer type processing apparatus 5.

### <9. Single wafer type processing apparatus>

The single wafer type processing apparatus 5 includes a carry-out block 81, an indexer block 83, and a processing block 85.

### <10. Carry-out block>

The carry-out block 81 includes a carry-out unit 87. The carry-out unit 87 is disposed at the front side X of the single wafer type processing apparatus 5. The carrier C is placed on the carry-out unit 87. The carry-out block 81 includes, for example, four carry-out units 87. The four carry-out units 87 are disposed along the width direction Y. The carry-out unit 87 is also called a load port.

### <11. Indexer block>

The indexer block 83 includes an indexer robot IR. The indexer robot IR includes, for example, an articulated arm 89 and a hand 91. The indexer robot IR does not move in the width direction Y and the front-back direction X. The indexer robot IR bends the articulated arm 89 and moves the hand 91. The indexer robot IR moves up and down the hand 91 in the vertical direction Z. The indexer robot IR can access each cassette C placed on the four carry-out units 87. The indexer robot IR transports one substrate W with the hand 91. The indexer robot IR transports one substrate W from the processing block 85 to the carry-out unit 87.

### <12. Processing block>

The processing block 85 includes four towers TW1 to TW4 and a center robot CR.

The tower TW1 is disposed at the front side X of the indexer block 83. The tower TW1 is disposed adjacent to the indexer block 83. The tower TW1 includes processing chamber-MPCs stacked in the vertical direction Z. The tower TW1 includes, for example, three processing chamber MPCs. Each of the processing chamber-MPCs processes the substrates W one by one. Each of the processing chamber-PMCs performs, for example, drying processing on the substrate W.

The tower TW2 is disposed at the back side X of the tower TW1. The tower TW2 is disposed adjacent to the tower TW1. The tower TW2 has the same configuration as the tower TW1. That is, the tower TW2 includes three processing chamber-MPCs stacked in the vertical direction Z.

The tower TW3 is disposed at the left side Y of the tower TW2. The tower TW3 is disposed at the left side Y of the tower TW2 with the center robot CR interposed therebetween. The tower TW3 also has the same configuration as the towers TW1 and TW2. That is, the tower TW3 includes three processing chambers MPCs stacked in the vertical direction Z.

The tower TW4 is partially different in configuration from the towers TW1 to TW4. That is, the tower TW4 includes the processing chamber-MPCs at the bottom and the top in the vertical direction Z. The tower TW4 includes a transfer unit 93 at the central portion in the vertical direction Z. One substrate W is placed on the transfer unit 93. The transfer unit 93 includes a lifting pin 93a. The lifting pin 93a is moved up and down when the substrate W is received from the bridge robot BR. One substrate W is placed on the transfer unit 93 from the bridge robot BR. In the transfer unit 93, one placed substrate W is received by the center robot CR.

The center robot CR is configured to be movable in the front-back direction X. The center robot CR includes a hand 95. The hand 95 moves up and down in the vertical direction Z. The hand 95 is configured to be rotatable in a plane including the front-back direction X and the width direction Y. The hand 95 is moved so as to be able to access the processing chamber-MPC and the transfer unit 93 of the towers TW1 to TW4. That is, the center robot CR can freely move the hand 95 in the vertical direction Z, the front-back direction X, and the width direction Y. The center robot CR transfers the processed substrate W to the indexer robot 83.

### <13. Description of operation>

An example of processing by the substrate processing apparatus 1 will be described with reference to FIGS. 1 and 2.

First, an overall outlined processing flow will be described.

### <14. Batch processing>

The carrier C accommodating a plurality of unprocessed substrates W is placed on the charging unit 19. The carrier C is carried into the stocker block 11 by the transport mechanism 23. Two sets of the plurality of substrates W are assembled as a batch lot by the first transport mechanism HTR and the transfer mechanism CTC. The plurality of substrates W constituting the batch lot are transported to the processing block 17 by the second transport mechanism WTR. In the processing block 17, for example, the etching processing with phosphoric acid is performed in the second batch processing unit BPU2. Thereafter, the plurality of substrates W constituting the batch lot are subjected to pure water cleaning processing by the first batch processing unit BPU1. Next, the plurality of substrates W constituting the batch lot are transported to the posture turning block 15 by the second transport mechanism WTR. In the posture turning block 15, only one of the batch lots is transported to the posture turning tank 33. In the posture turning tank 33, only one of the batch lots turns the posture of the plurality of substrates W in the vertical posture to the horizontal posture in the liquid. Thereafter, the plurality of substrates W constituting one lot of the batch lot are sequentially transported one by one to the single wafer type processing apparatus 5. Thereafter, the posture of another one of the batch lots is similarly turned, and then transported to the single wafer type processing apparatus 5.

### <15. Single wafer processing>

The one substrate W turned to the horizontal posture is transported to the single wafer type processing apparatus 5 by the bridge robot BR. Specifically, one substrate W is placed on the transfer unit 93. One substrate W placed on the transfer unit 93 is received by the center robot CR. The center robot CR carries one substrate W into, for example, the processing chamber-MPC of the tower TW1. In the processing chamber-MPC, for example, the substrate W is subjected to a drying processing. Specifically, for example, pure water is supplied while rotating the substrate W. Thereafter, IPA is supplied to the substrate W to replace pure water of the substrate W with IPA. Thereafter, the substrate W is rotated at a high speed and dried. In addition, it is preferable to perform a drying processing with carbon dioxide of the supercritical fluid in another processing chamber MPC as necessary. The finish drying processing is performed on the substrate W by the drying processing with the supercritical fluid. As a result, the substrate W is completely dried, but collapse of the pattern formed on the substrate W is suppressed.

One substrate W subjected to the drying processing is carried out to the carry-out unit 87 via the center robot CR and the indexer robot IR. The indexer robot IR accommodates one substrate W in the carrier C placed on the carry-out unit 87. The substrates W constituting the same lot to be processed subsequently are housed in the same carrier C.

### <16. Posture turn processing>

Although the above is an outlined processing flow by the substrate processing apparatus 1, the posture turning will be described below.

The plurality of substrates W constituting the batch lot subjected to the batch processing are transferred to the lifter LF0 of the standby tank 31 by the second transport mechanism WTR. The lifter LF0 moves the plurality of substrates W constituting the batch lot to the standby position inside the standby tank 31. Since the plurality of substrates W constituting the batch lot stand by in this state, drying can be prevented. That is, collapse of a pattern or the like formed on the substrate W after batch processing can be prevented.

The 25-piece chuck TFC is located at the first transfer position P1. The 25-piece chuck TFC opens the hand 35. That is, in the 25-piece chuck TFC, the hand 35 is at the passing position PT (refer to FIG. 3). The lifter LF0 is moved up to the transfer position above the liquid level of the standby tank BB0. At this time, since the hand 35 is at the passing position PT in the 25-piece chuck TFC, the plurality of substrates W can pass between the 25-piece chucks TFC and move up. At the same time, the reversing chuck 43 is moved up to the receiving height HP1 by the posture turning unit 41 in the posture turning tank 33.

The 25-piece chuck TFC closes the hand 35. That is, in the 25-piece chuck TFC, the hand 35 is at the holding position PC (refer to FIG. 3). In this state, the lifter LF0 is moved down to the standby position. As a result, among the plurality of substrates W of the batch lot placed on the lifter LF0, only the plurality of odd numbered substrates W constituting one lot are placed on the 25-piece chucks TFC. Among the plurality of substrates W of the batch lot placed on the lifter LF0, the plurality of even-numbered substrates W constituting another lot descend into the standby tank BB0 together with the lifter LF0. As a result, the hand 35 of the 25-piece chuck TFC is set to the second transfer position PT2, which allows the even-numbered substrates W to standby in a state being prevented from drying until they are moved to the posture turning tank 33. Therefore, pattern collapse due to drying of the plurality of substrates W constituting another lot can also be prevented.

The 25-piece chuck TFC advances the hand 35 toward the right side Y up to the third transfer position P3. At this time, since the reversing chuck 43 is positioned at the receiving height HP1, interference with the substrate W does not occur.

The reversing chuck 43 is set to the first interval WD1 by deactivating the air cylinder 63b of the drive mechanism 61 (refer to FIG. 4). In this state, the reversing chuck 43 is moved down to the plurality of substrates W placed on the 25-piece chuck TFC. Specifically, the reversing chuck 43 is moved down to the clamping height HP2. The plurality of substrates W are accommodated in the reversing chuck 43.

The reversing chuck 43 is set to the second interval WD2 by operating the air cylinder 63b of the drive mechanism 61 (refer to FIG. 5). As a result, the substrates W accommodated in the reversing chuck 43 are clamped. Further, as illustrated in FIG. 6, the reversing chuck 43 is moved up to a locking height HP3. As a result, among lower edge portions of the end surfaces of the substrates W clamped by the reversing chuck 43, the lower edge portions being located below the side, abut on and are locked. The 25-piece chuck TFC is moved to the second transfer position P2 in a state where the reversing chuck 43 is temporarily moved up to the receiving height HP1. As a result, the 25-piece chuck TFC is ready to receive the plurality of substrates W constituting another lot placed on the lifter LF0.

The reversing chuck 43 is moved down to the immersion height HP4 by driving the motor 61c of the lifting mechanism 61. As a result, the plurality of substrates W clamped by the reversing chuck 43 are immersed in the processing liquid in the immersion tank DB. The entirety of the plurality of substrates W is immersed under the processing liquid in the immersion tank DB. In the posture turning block 15, the plurality of substrates W constituting one lot are in a state of being exposed from the liquid for a short time until being raised from the standby tank BB0 and immersed in the immersion tank DB.

The reversing chuck 43 is rotated by 90° by operating the motor 65b of the rotating mechanism 65. Specifically, in this example, it is rotated clockwise by 90°. The rotation direction may be determined by in which direction the processing surface (front face) of the substrate W is located. That is, the rotation direction may be determined such that the processing surface of the substrate W faces upward. As a result, the plurality of substrates W are turned to the horizontal posture.

The reversing chuck 43 is moved up by operating the motor 61b of the lifting mechanism 61. Specifically, the reversing chuck 43 is moved upward such that only the substrate W clamped by the uppermost groove portion 47 of the reversing chuck 43 is exposed from the liquid in the immersion tank DB. The height of the reversing chuck 43 is as high as the hand 71 of the bridge robot BR can enter a position slightly separated downward from the lower surface of the substrate W exposed from the liquid.

The hand 71 of the bridge robot BR enters the posture turning unit 41. The hand 71 enters a position slightly separated downward from the lower surface of the substrate W.

The reversing chuck 43 is moved downward. The substrate W is transferred to the hand 71 by the movement of the reversing chuck 43.

The bridge robot BR moves the hand 71 to the right side Y to remove the uppermost substrate W from the reversing chuck 43.

The bridge robot BR rotates the hand 71 to position the substrate W at the right side Y. Specifically, the hand 71 is rotated to move the substrate W toward the transfer unit 93. Then, one substrate W is transferred to the transfer unit 93.

By the operation of the posture turning block 15 described above, one substrate W is transported in a horizontal posture from the batch type processing apparatus 3 to the single wafer type processing apparatus 5.

The correspondence relationship between the present invention and the above-described embodiments is as follows.

The posture turning tank 33 corresponds to the "in-liquid posture turning apparatus" and the "in-liquid posture turning unit" in the present invention. The batch type processing apparatus 3 corresponds to a "batch type processing unit" in the present invention. The single wafer type processing apparatus 5 corresponds to a "single wafer type processing unit" in the present invention. The 25-piece chuck TFC corresponds to a "first transport unit" in the present invention. The bridge robot BR corresponds to a "second transport unit" in the present invention. The drive mechanism 63 corresponds to an "opening/closing drive mechanism" in the present invention. The rotating mechanism 65 corresponds to a "rotating drive mechanism" in the present invention. The lifting mechanism 61 corresponds to a "lifting drive mechanism" in the present invention. The first interval WD1 corresponds to an "open position" in the present invention. The second interval WD2 corresponds to a "holding position" in the present invention. A receiving height HP1 corresponds to the "transfer position" in the present invention. The immersion height HP4 corresponds to the "turning position" in the present invention.

According to the present embodiment, the reversing chuck 43 is moved up to the receiving height HP1 by the lifting mechanism 61. The reversing chuck 43 having the first interval WD1 is caused to receive the plurality of substrates W by the drive mechanism 63, and the reversing chuck 43 is caused to have the second interval WD2 by the drive mechanism 63. The reversing chuck 43 is moved down to the immersion height HP4 by the lifting mechanism 61. The rotating mechanism 65 drives the reversing chuck 43 around the axis AX1. As a result, the posture of the plurality of substrates W can be turned in the immersion tank DB. Since the plurality of substrates W are held by the reversing chuck 43 instead of the in-tank carrier, the immersion tank DB can be downsized. In addition, since only the plurality of substrates W and the reversing chuck 43 are rotated around the axis AX1, the load on the rotating mechanism 65 can be reduced.

### <17. Modification of posture turning tank>

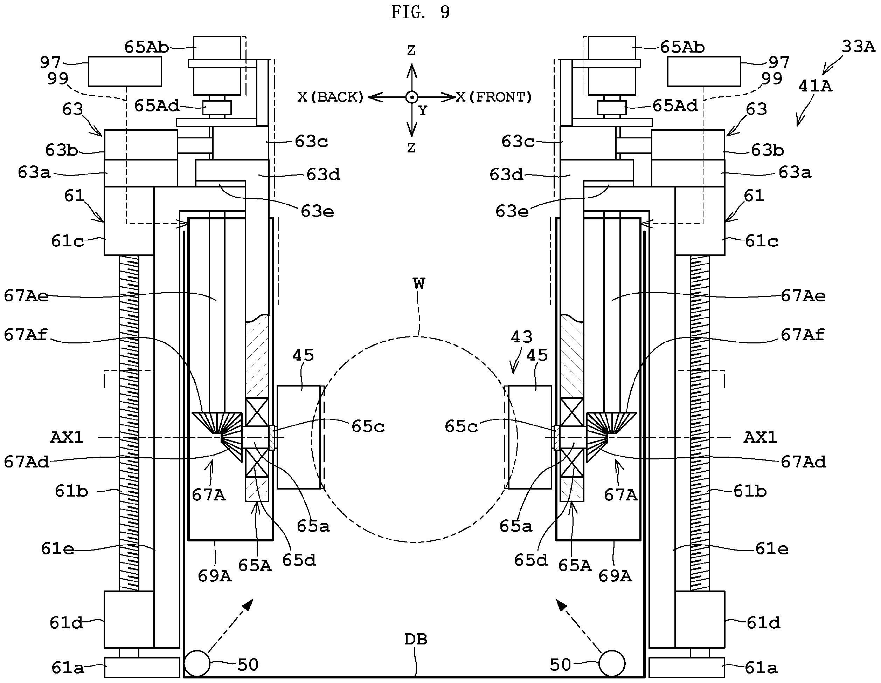

Here, refer to FIG. 9. FIG. 9 is another embodiment of the posture turning tank, and is a partially broken front view showing a detailed structure.

A posture turning tank 33A is different from the posture turning tank 33 described above in the configuration of a posture turning unit 41A. Specifically, in the posture turning unit 41A, a rotating mechanism 65A, a transmission mechanism 67A, and a container 69A are different.

The rotating mechanism 65A includes a rotating shaft 65a, a motor 65Ab, a seal member 65c, and a coupling 65Ad.

The transmission mechanism 67A includes a first bevel gear 67Ad, an extension shaft 67Ae, and a second bevel gear 67Af. The first bevel gear 67Ad is attached to the other end of the rotary shaft 65a.

In the rotating mechanism 65A, the motor 65Ab is vertically disposed above the drive mechanism 63. The motor 65Ab is coupled to one end of the extension shaft 67Ae via the coupling 65Ad. Since the extension shaft 67Ae and the motor 65Ab are coupled via the coupling 65Ad, the motor 65Ab can be easily replaced. The other end of the extension shaft 67Ae is attached with the second bevel gear 67Af. The second bevel gear 67Af is screwed with the first bevel gear 67Ad. The axes of the rotary shaft 65a and the extension shaft 67Ae are substantially orthogonal to each other. The first bevel gear 67Ad and the second bevel gear 67Af transmit the rotational force of the motor 65Ab in a substantially orthogonal direction. According to this modification, since the rotational force of the motor 65Ab is transmitted by the first bevel gear 67Ad and the second bevel gear 67Af, it is possible to reduce the transmission loss of the rotational force as compared with the method of the above-described timing belt 67c.

The container 69A accommodates the transmission mechanism 67A in a sealed manner. It is preferable that the container 69A is pressurized. Specifically, one end of the supply pipe 99 is communicatively connected to a pressurization source 97. The other end of the supply pipe 99 is communicably connected to the container 69A. The pressurization source 97 supplies gas to the supply pipe 99. The gas is, for example, nitrogen gas or air. The gas is supplied at a constant pressure. Therefore, it is possible to prevent the processing liquid in the immersion tank DB from entering the container 69A. As a result, it is possible to prevent the transmission mechanism 67A from failing due to the processing liquid entering the container 69A.

### <18. Another operation example regarding posture turning tank>

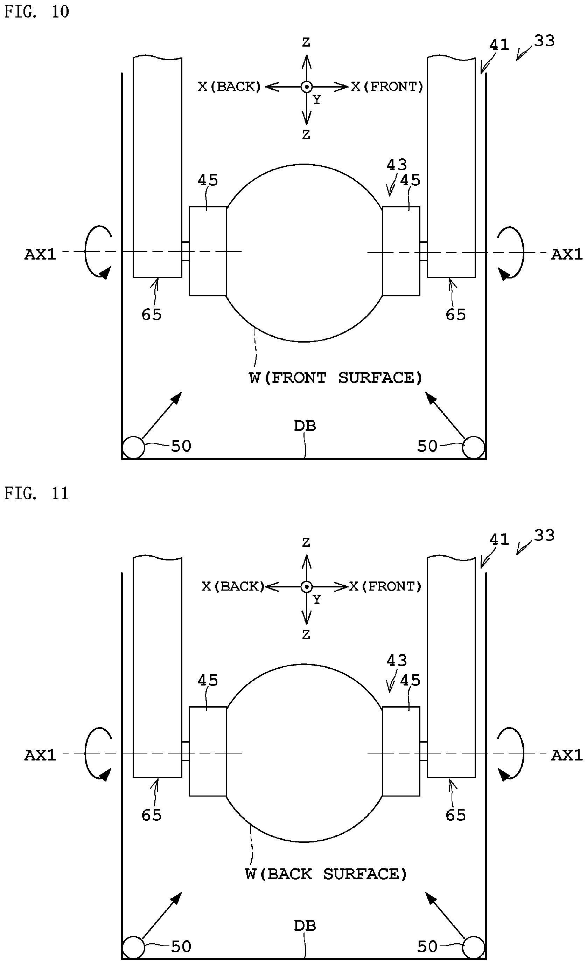

Another operation example of the posture turning tank 33 described above will be described with reference to FIGS. 10 and 11. FIGS. 10 and 11 are front views for explaining another operation example by the posture turning tank.

In the above-described embodiment, the posture turning tank 33 is used only to turn the posture of the plurality of substrates W from the vertical posture to the horizontal posture. That is, the posture turning tank 33 turns the posture of the plurality of substrates W by 90 degrees. However, the posture turning tank 33 may be used to operate as follows.

That is, the posture turning tank 33 can also be used as the batch processing unit BPU that collectively processes the plurality of substrates W. That is, the posture turning tank 33 is used as the processing tank BB of the batch processing unit BPU.

For example, the plurality of substrates W are processed while the processing liquid is supplied from the supply pipe 50. The processing liquid is, for example, a chemical liquid, and specific examples thereof include a phosphoric acid solution. The rotating mechanism 65 causes the reversing chuck 43 to hold the plurality of substrates W in a vertical posture. Further, the reversing chuck 43 is moved to the immersion height HP4 by the lifting mechanism 61. This state is illustrated in FIG. 10. At this time, for example, the front surfaces (processing surfaces) of the plurality of substrates W are oriented to one side in the width direction Y. As a result, the processing with the chemical liquid is started for the plurality of substrates W. Next, in a case where the processing time with the chemical liquid is set to T hours, for example, the rotating mechanism 65 is operated at the time of T/2 hours. Then, the posture of the plurality of substrates W are turned by 180 degrees. That is, the posture is set to the vertical posture in which the upper and lower sides of the plurality of substrates W are inverted. As a result, the back surface (un-processing surface) is oriented to one side in the width direction Y. The plurality of substrates W are turned such that an upper portion thereof is positioned at a lower portion and a lower portion thereof is positioned at an upper portion. Then, for example, when T/2 hours have elapsed, the processing tank is moved to another processing tank BB to perform the cleaning processing.

With this operation example, the plurality of substrates W are caused to be processed with the processing liquid in the immersion tank DB, and the reversing chuck 43 is driven around the axis AX1 by the rotating mechanism 65 to vertically invert the plurality of substrates W. Therefore, the upper portion and the lower portion of the substrate W can be inverted. Therefore, even if the degree of progress of the processing is different between the upper portion and the lower portion of the substrate W, the degree of progress of the processing can be averaged by the inversion. As a result, the in-plane uniformity of the processing on the substrate W can be enhanced.

In the operation example described above, the upper and lower sides are inverted by T/2 hours in the processing time of the T hours. However, the present invention is not limited to this, and the time may be allocated according to a variation in the degree of progress of the processing in the vertical direction. In addition, vertical inversion may be performed a plurality of times.

The present invention is not limited to the embodiment described above, but may be modified as follows.
(1) In the above-described embodiment, the drive mechanism 63 is driven by the air cylinder 63b, but the present invention is not limited to such a configuration. For example, instead of the air cylinder 63b, an air type rotating actuator, a linear motor, and the like may be used.
(2) In the embodiment described above, the transmission mechanisms 67, 67A uses the main driving pulley 67b and the first bevel gear 67Ad, but the present invention is not limited to such a configuration. That is, the present invention is not limited to such a configuration as long as the driving force of the motors 65b, 65Ab can be transmitted to the reversing chuck 43.
(3) In the above-described embodiment, the lifting mechanism 63 includes the motor 61c and the screw shaft 61b. However, the present invention is not limited to such a configuration. For example, instead of the motor 61c and the screw shaft 61b, a plurality of air cylinders or multistage air cylinders may be used.
(4) In the above-described embodiments, the configuration in which the substrate processing apparatus 1 couples the batch type processing apparatus 3 and the single wafer type processing apparatus 5 by the bridging unit 7 has been described as an example. However, the present invention can also be applied to one substrate processing apparatus 1 including the batch type processing apparatus 3 and the single wafer type processing apparatus 5 in the same housing.

The present invention may be embodied in other specific forms without departing from the spirit or essential attributes thereof and, accordingly, reference should be made to the appended claims, rather than to the foregoing specification, as indicating the scope of the invention.

## Claims

1. An in-liquid posture turning apparatus that turns a posture of a plurality of substrates, the apparatus comprising:
an immersion tank that stores a processing liquid;
a reversing chuck that holds a plurality of substrates;
an opening/closing drive mechanism that drives the reversing chuck to an open position for transferring the plurality of substrates to the reversing chuck and a holding position for holding the plurality of substrates by the reversing chuck;
a rotating drive mechanism that drives the reversing chuck about a horizontal axis in order to turn the posture of the plurality of substrates; and
a lifting drive mechanism that moves the reversing chuck up and down between a transfer position above the immersion tank and a turning position in the immersion tank, wherein
in a state where the reversing chuck is moved up to the transfer position by the lifting drive mechanism, the reversing chuck, which has been set to the open position by the opening/closing drive mechanism, is made to receive the plurality of substrates, and after the inversion chuck is set to the holding position by the opening/closing drive mechanism, in a state where the inversion chuck is moved down to the turning position by the lifting drive mechanism, the reversing chuck is driven around a horizontal axis by the rotating drive mechanism.

2. The in-liquid posture turning apparatus according to claim 1, wherein
the rotating drive mechanism includes a rotary shaft whose one end side is coupled to the outside of the reversing chuck, a motor, and a transmission mechanism that transmits a rotational force of the motor to the rotary shaft,
the rotating drive mechanism further includes a bottomed container that accommodates the rotary shaft and the transmission mechanism, and
the transmission mechanism is moved up and down together with the container by the lifting drive mechanism.

3. The in-liquid posture turning apparatus according to claim 2, wherein
the transmission mechanism includes
a driven pulley provided on the other end side of the rotary shaft,
a main driving pulley attached to the motor, and
a timing belt stretched between the driven pulley and the main driving pulley.

4. The in-liquid posture turning apparatus according to claim 2, wherein
the transmission mechanism includes
a first bevel gear provided on the other end side of the rotary shaft,
an extension shaft coupled to the motor, and
a second bevel gear provided at a lower end portion of the extension shaft and screwed with the first bevel gear.

5. The in-liquid posture turning apparatus according to claim 2, wherein
the lifting drive mechanism includes a lifting frame on which the rotating drive mechanism is mounted and which extends to the outside of the immersion tank and the container, and
the opening/closing drive mechanism is mounted on the lifting frame.

6. The in-liquid posture turning apparatus according to claim 4, wherein the container is internally pressurized with gas.

7. A substrate processing apparatus for processing a substrate, the apparatus comprising:
a batch type processing unit that collectively processes a plurality of substrates in a vertical posture;
a single wafer type processing unit that processes one substrate in a horizontal posture;
an in-liquid posture turning unit that turns a vertical posture to a horizontal posture in a processing liquid for the plurality of substrates that have been processed by the batch type processing unit;
a first transport unit that transports the plurality of substrates, which have been processed by the batch-type processing unit, to the in-liquid posture turning unit; and
a second transport unit that transports the plurality of substrates brought into a horizontal posture by the in-liquid posture turning unit to the single wafer type processing unit, wherein
the in-liquid posture turning unit includes,
an immersion tank that stores a processing liquid
a reversing chuck that holds a plurality of substrates,
an opening/closing drive mechanism that drives the reversing chuck to an open position for transferring the plurality of substrates to the reversing chuck and a holding position for holding the plurality of substrates by the reversing chuck,
a rotating drive mechanism that drives the reversing chuck about a horizontal axis in order to turn a posture of the plurality of substrates into a vertical posture and a horizontal posture, and
a lifting drive mechanism that moves up and down the reversing chuck between a transfer position above the immersion tank and a turning position in the immersion tank,
in a state where the reversing chuck is moved up to the transfer position by the lifting drive mechanism, the reversing chuck, which has been set to the open position by the opening/closing drive mechanism, is made to receive the plurality of substrates, and after the inversion chuck is set to the holding position by the opening/closing drive mechanism, in a state where the inversion chuck is moved down to the turning position by the lifting drive mechanism, the reversing chuck is driven around a horizontal axis by the rotating drive mechanism so as to turn the plurality of substrate from the vertical posture to the horizontal posture.
